# EUROPÄISCHE PATENTSCHRIFT

(11) **EP 3 038 829 B1**
(45) Veröffentlichungstag und Bekanntmachung des Hinweises auf die Patenterteilung: **15.05.2019**
(21) Anmeldenummer: 14748226.9
(22) Anmeldetag: 08.08.2014
(51) Int. Cl.: B32B 37/12, B32B 38/10, G06K 19/077, H05K 3/02

(54) **VERFAHREN UND SYSTEM ZUM HERSTELLEN EINES MEHRSCHICHTELEMENTS SOWIE MEHRSCHICHTELEMENT**
METHOD AND SYSTEM FOR PRODUCING A MULTI-LAYER ELEMENT, AND MULTI-LAYER ELEMENT
PROCÉDÉ ET SYSTÈME DE FABRICATION D'UN ÉLÉMENT MULTICOUCHE ET ÉLÉMENT MULTICOUCHE

(30) Priorität: 30.08.2013 DE 102013217348
(43) Veröffentlichungstag der Anmeldung: 06.07.2016
(73) Patentinhaber: 3D-Micromac AG, 09126 Chemnitz (DE)
(72) Erfinder: ALLENSTEIN, Frank, 09116 Chemnitz (DE); CLAIR, Maurice, 08529 Plauen (DE); PETSCH, Tino, 09127 Chemnitz (DE); KUNDT, Rocco, 09326 Geringswalde (DE)
(74) Vertreter: Patentanwälte Ruff, Wilhelm, Beier, Dauster & Partner mbB
(86) Internationale Anmeldenummer: PCT/EP2014/067104
(87) Internationale Veröffentlichungsnummer: WO 2015/028289

(56) Entgegenhaltungen:
- WO-A1-2009/118455
- WO-A1-2011/003518
- WO-A1-2013/178588
- US-A1- 2007 012 775

## Beschreibung

### HINTERGRUND

Die Erfindung betrifft ein Verfahren zum Herstellen eines Mehrschichtelements mit einem Substrat und mindestens einer mit dem Substrat flächig verbundenen Leiterstruktur gemäß dem Oberbegriff von Anspruch 1, ein System zum Herstellen eines derartigen Mehrschichtelements gemäß dem Oberbegriff von Anspruch 10 sowie ein durch das Verfahren erhältliches Mehrschichtelement.

Ein bevorzugtes Anwendungsgebiet ist die Herstellung von Antennen für Radiofrequenz-Identifikationssysteme (RFID-Antennen), flexiblen Leiterplatten oder anderen mittels Laminierung herstellbaren Mehrschichtelementen mit leitfähigen Strukturen z.B. für elektrische Schaltungen, unter Verwendung von flexiblen bandförmigen Substraten in einem Rolle-zu-Rolle-Verfahren.

Bei der Herstellung von elektrischen oder elektronischen Komponenten für Massenanwendungen ist man bestrebt, die gewünschte elektrische Funktionalität in guter Qualität bei möglichst geringen Herstellungskosten bereitzustellen. Bei einer Klasse von Herstellungsverfahren wird als Zwischenprodukt ein Laminat hergestellt, indem eine Leiterfolie, insbesondere eine Metallfolie, mit dem Substrat mittels einer zwischenliegenden Kleberschicht verbunden wird. Anschließend wird die Leiterfolie strukturiert, indem sie an den Grenzen derjenigen Bereiche, die später die Leiterstruktur bilden sollen, durch ein geeignetes Trennverfahren, beispielsweise Laserschneiden, Stanzen etc., durchtrennt wird. Dabei werden in vielen Fällen relativ große Folienstücke erzeugt, die nicht zum Endprodukt gehören und dementsprechend vom Zwischenprodukt entfernt werden müssen, bevor sich weitere Verfahrensschritte anschließen können.

Das europäische Patent EP 0 790 123 B1 bzw. die entsprechende DE 697 34 328 T2 beschreiben ein Verfahren zum Herstellen eines Laminats aus einer gemusterten Metallfolie und einem Substrat, bei dem eine Metallfolienbahn auf ein Substrat laminiert wird, indem ein Kleber zwischen die Metallfolie und das Substrat in einem vorbestimmten Muster eingebracht wird. Das Muster definiert Bereiche, in denen Kleber vorhanden ist sowie Bereiche, in denen kein Kleber vorhanden ist. Anschließend wird die Metallfolie in ein Muster geschnitten, das den Grenzen der den Kleber enthaltenden Bereiche entspricht. Das Schneiden kann beispielsweise mittels Rotationsstanzen oder durch Laserschneiden erfolgen. Diejenigen Bereiche von Metallfolie, die nicht mit dem Kleber auf das Substrat aufgeklebt sind, werden anschließend z.B. durch Absaugen entfernt.

Die WO 2009/118455 A1 offenbart andere gattungsgemäße Verfahren. Bei einer Verfahrensvariante wird eine Leiterfolie selektiv am Substratmaterial befestigt, wobei gewünschte Bereiche des Endprodukts, welche die finale Leiterstruktur bilden, sowie schmale Bereiche zwischen den leitenden Bereichen des Endprodukts, mittels eines Klebers mit dem Substrat verbunden werden und lateral ausgedehnte Bereiche der Folie, welche später beseitigt werden sollen, im Wesentlichen ohne Verbindung zum Substrat verbleiben derart, dass sie höchstens in einem Randbereich, der in einem späteren Strukturierungsschritt entfernt wird, mit dem Substrat verbunden sind. Anschließend wird die Leiterfolie durch Entfernen von Material von schmalen Bereichen zwischen den gewünschten Bereichen der Leiterstruktur sowie vom äußeren Rand der größeren Folienbereiche, die später am Stück entfernt werden sollen, durch Materialbeseitigung strukturiert, um die Leiterstruktur zu erzeugen. Danach werden die nicht mehr am Substrat befestigten Folienstücke entfernt, nachdem der Randbereich dieser Folienstücke, der während der Strukturierungsoperation vom äußeren Rand dieser Folienstücke entfernt wurde, die Folienstücke nicht mehr am Substrat festhält.

Die US 2007/0012775 A1 offenbart ein Verfahren zum Herstellen eines Mehrschichtelements gemäß dem Oberbegriff von Anspruch 1. Das hergestellte Mehrschichtelement hat ein Substrat und eine mit dem Substrat flächig verbundene Leiterstruktur aus einer leitfähigen Folie. Bei der Herstellung wird zunächst eine lateral strukturierte Kleberschicht auf das Substrat aufgebracht, indem Kleber in gewissen Bereichen aufgebracht wird und zwischen diesen Bereichen kleberfreie Bereiche liegen. Dann wird die Leiterfolie auf die strukturierte Kleberschicht aufgebracht, so dass sie in den mit Kleber belegten Bereichen am Substrat haftet und die zwischen den mit Kleber belegten Bereichen liegenden Zwischenbereiche überbrückt. Danach wird die Leiterfolie entsprechend dem Muster der mit Kleber belegten Bereiche mithilfe einer Schneideinrichtung an den Rändern der mit Kleber belegten Bereiche durchtrennt. Dadurch entsteht eine lateral strukturierte Leiterstruktur, deren elektrisch leitendes Material nach dem gleichen Muster auf dem Substrat verteilt ist wie das Klebermaterial. Nach dem Schritt des Strukturierens der Leiterfolie mithilfe der Schneideinrichtung liegen somit an dem Mehrschichtelement erste Bereiche aus elektrisch leitendem Material vor, welche nach einem vorgegebenen Muster vorliegen, und zwischen den ersten Bereichen liegen elektrisch nicht leitende zweite Bereiche. In den ersten Bereichen, also dort, wo elektrisch leitendes Material in Kontakt mit dem Substrat verbleiben soll, liegen die jeweiligen Kleberbereiche der strukturierten Kleberschicht vollflächig zwischen dem Substrat und dem vom Kleber gehaltenen Folienstück, so dass ein vollflächiger Haftkontakt zwischen der verbleibenden Leiterfolie und dem Substrat vorliegt.

### AUFGABE UND LÖSUNG

Der vorliegenden Erfindung liegt die Aufgabe zugrunde, ein Verfahren und ein System zum Herstellen eines Mehrschichtelements der eingangs erwähnten Art bereitzustellen, die die Herstellung qualitativ hochwertiger Mehrschichtelemente mit hoher Prozesssicherheit bei niedrigen Herstellungskosten erlauben.

Zur Lösung dieser Aufgaben stellt die Erfindung ein Verfahren mit den Merkmalen von Anspruch 1 bereit. Weiterhin wird ein System mit den Merkmalen von Anspruch 10 bereitgestellt. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Bei dem Verfahren wird die Leiterfolie mit dem Substrat mittels einer zwischenliegenden, räumlich strukturierten Kleberschicht derart verbunden, dass in ersten Bereichen, welche im Endprodukt das gewünschte elektrisch leitende Leitermaterial aufweisen sollen, ein partieller Haftkontakt zwischen dem Substrat und der Leiterfolie an einer Vielzahl von über den ersten Bereich verteilten Haftzonen erzeugt wird. Zwischen Haftzonen liegen Zwischenbereiche, in denen kein Kleber vorliegt. Diese Zwischenbereiche werden durch die Leiterfolie überbrückt. In lateral ausgedehnten zweiten Bereichen, die am Endprodukt elektrisch nicht leitend sein sollen, wird dagegen nur ein geringerer oder gar kein Haftkontakt zwischen dem Substrat und der Leiterfolie erzeugt. Hier erfolgt also kein Kleberaufrag oder es wird nur an wenigen Stellen Kleber so aufgetragen, dass sich nur ein schwacher Haftkontakt ergibt, der in jedem Fall geringer ist als der Haftkontakt in den ersten Bereichen.

Danach wird die Leiterfolie durch Schneiden bzw. Trennen der Leiterfolie entlang von Grenzen der ersten Bereiche strukturiert, wodurch aus der vorher zusammenhängenden Leiterfolie diejenigen Bereiche herausgearbeitet werden, die am fertigen Produkt die gewünschte Leiterstruktur bilden. Diese Bereiche bleiben an den Haftzonen der ersten Bereiche haften. Die zwischen den Haftzonen liegenden kleberfreien Zwischenbereiche werden durch die Leiterfolie überbrückt.

Bei dieser Strukturierungsoperation werden Folienstücke der Leiterfolie in lateral ausgedehnten zweiten Bereichen, die an die Bereiche mit Leiterstruktur angrenzen, freigelegt. Die Folienstücke werden nach der Strukturierungsoperation aus den lateral ausgedehnten zweiten Bereichen entfernt. Da in den zweiten Bereichen keine oder nur eine geringe Haftkraft vorliegt, weil nur wenig oder gar kein Kleber aufgetragen wurde, ist diese Ablösung leicht möglich. Die Ablösekraft wird so eingestellt, dass Folienstücke in den ersten Bereichen nicht abgelöst, sondern im Bereich der Haftzonen zuverlässig am Substrat festgehalten werden.

Der Begriff "Haftzonen" bezeichnet in dieser Anmeldung relativ kleinflächige Zonen, in denen zwischen Substrat und Leiterfolie ein durch Kleber vermittelter Haftkontakt besteht. Haftzonen haben in mindestens einer in der Fläche liegenden Richtung einen lateralen Abstand zueinander, so dass ein kleberfreier Zwischenbereich vorliegt. Haftzonen können relativ klein sein und beispielsweise an ihrer schmalsten Stelle einen Durchmesser im Bereich von 10 µm bis zu 300 µm haben, ggf auch darunter oder darüber. Die Größe kann durch Besonderheiten der Herstellungstechnik bedingt sein (z.B. Siebdruck- oder Ink-Jet-Verfahren)

Ein "lateral ausgedehnter zweiter Bereich" im Sinne dieser Anmeldung hat typischerweise in mehrere Richtungen eine Ausdehnung, die um ein Vielfaches größer ist als die Schnittbreite der Strukturierungsoperation, z.B. mindestens 10 mal oder mindestens 100 mal oder mindestens 1000 mal so groß. Die Ausdehnung lateral ausgedehnter Bereiche kann z.B. an der schmalsten Stelle mindestens 300 µm oder mindestens 500 µm oder mindestens 1 mm betragen und/oder an der breitesten Stelle mindestens 10 mm. Lateral ausgedehnte zweite Bereiche können z.B. bei in Umfangsrichtung geschlossenen Leiterstrukturen, wie sie für Antennen oder Spulen gelegentlich genutzt werden, im Inneren der Leiterstruktur liegen. Auch zwischen Leiterstrukturen, die auf demselben Substrat mit Abstand zueinander benachbart liegen, können größere lateral ausgedehnte zweite Bereiche liegen.

In manchen Anwendungsfällen gibt es auch zweite Bereiche kleinerer lateraler Dimensionen, z.B. zwischen eng benachbart verlaufenden Leiterbahnen der Leiterstruktur. In diesen zweiten Bereichen kann das Leitermaterial bereits bei der Strukturierungsoperation entfernt werden, z.B. durch Laserablation (Materialabtrag mittels Laserstrahlung).

Das Verfahren bietet zahlreiche Vorteile. Da in den ersten Bereichen kein vollflächiger Kleberauftrag, sondern nur ein partieller Kleberauftrag erfolgt, kann im Vergleich zum Stand der Technik bei im Wesentlichen gleicher Kleberschichtdicke in erheblichem Umfang Klebstoff gespart werden. Da die Klebstoffkosten einen erheblichen Teil der Materialkosten bei der Herstellung gattungsgemäßer Mehrschichtelemente ausmachen können, können Kosten gespart werden. Gleichzeitig können erfindungsgemäße Mehrschichtelemente bei gleicher Struktur der Leiterfolie und gleicher Kleberschichtdicke leichter als vergleichbare herkömmliche Mehrschichtelemente sein. Die Gewichtsreduzierung gegenüber herkömmlichen Mehrschichtelementen kann Vorteile beim Transport und bei der Lagerung großer Stückzahlen von Mehrschichtelementen sowie im Gebrauch bringen. Weiterhin kann das Spektrum der prinzipiell nutzbaren Klebstoffe erweitert werden. Während bei vollflächigen Kleberschichten auf flexiblen Substraten auch darauf geachtet werden muss, dass der Kleber im ausgehärteten Zustand ausreichend flexibel bzw. dehnbar ist, um Kleberbruch zu vermeiden, können bei erfindungsgemäßen Verfahren auch sprödere Klebstoffe genutzt werden, da das Klebermaterial nur in den relativ kleinen Bereichen der Haftzonen vorhanden ist, die durch Biegung nicht oder kaum beansprucht werden. Die Unterbrechung der Kleberschicht in den ersten Bereichen zwischen den Haftzonen führt auch zu einer besseren Biegbarkeit der fertigen Mehrschichtelemente, da in der vielfach unterbrochenen Kleberschicht vordefinierte Unterbrechungszonen (die Zwischenbereiche) liegen, die sich bei Biegebeanspruchung bevorzugt verbiegen würden.

Um ausreichende Haftkraft in den ersten Bereichen zu erzielen, wir Kleber vorzugsweise so aufgetragen, dass ein Flächenanteil von Kleber zur Erzeugung der Haftzonen innerhalb der ersten Bereiche zwischen 10% und 90% liegt, insbesondere im Bereich von 20% bis 80%. Innerhalb dieser Grenzen ist ein guter Kompromiss zwischen ausreichender Haftkraft und Klebereinsparung in der Regel möglich.

Bei manchen Varianten wird in Bereichen, die lateral ausgedehnten zweiten Bereichen entsprechen, kein Klebstoff aufgetragen, so dass diese Bereiche am fertigen Mehrschichtelement kleberfrei sind. Vorzugsweise gilt dies für alle lateral ausgedehnten zweiten Bereiche, es könnten jedoch auch einige dieser Bereiche etwas Kleber enthalten. Diese Varianten können z.B. im Hinblick auf Kleberkosten, Gesamtgewicht und Flexibilität des Mehrschichtelements besonders vorteilhaft sein.

Es ist auch möglich, in einigen oder allen lateral ausgedehnten zweiten Bereichen einen partiellen Haftkontakt zwischen Substrat und Leiterfolie herzustellen, indem Kleber nach einem vorgegebenen Muster so aufgetragen wird, dass eine räumliche Verteilung von Haftzonen mit zwischenliegenden kleberfreien Zwischenbereichen entsteht. Um sicherzustellen, dass bei der Reinigung zusammenhängende Folienstücke nur aus den lateral ausgedehnten zweiten Bereichen entfernt werden, sollte der Flächenanteil von Kleber zur Erzeugung der Haftzonen in diesem Fall wesentlich geringer sein als der Flächenanteil des Klebermaterials in den ersten Bereichen. Beispielsweise kann ein Flächenanteil von Kleber zur Erzeugung von Haftzonen bzw. der Bedeckungsgrad dieser Bereiche innerhalb der lateral ausgedehnten zweiten Bereiche bei weniger als 30% liegen, beispielsweise zwischen 1% und 5%, während der Flächenanteil bzw. Bedeckungsgrad in den ersten Bereichen 20% oder mehr beträgt und beispielsweise im Bereich von 40% bis 90% liegt.

Um die Haftzonen zu erzeugen, wird vor dem Verbinden der Leiterfolie mit dem Substrat eine lateral strukturierte Kleberschicht auf das Substrat und/oder auf die Leiterfolie aufgetragen. Eine Auftragung ausschließlich auf das Substrat ist in vielen Fällen vorteilhaft, insbesondere dann, wenn das Substrat deutlich dicker und/oder mechanisch stabiler als die Leiterfolie ist. Alternativ ist es auch möglich, eine Kleberschicht ausschließlich auf die dem Substrat zuzuwendende Seite der Leiterfolie aufzubringen, was insbesondere dann vorteilhaft sein kann, wenn die Leiterfolie dicker und/oder mechanisch stabiler als das Substratmaterial ist. Es ist auch möglich, einen Anteil der Kleberschicht auf das Substrat und einen anderen Anteil auf die Leiterfolie aufzutragen, wobei sich die Anteile dann beim Verbinden zu der gewünschten lateral strukturierten Kleberschicht ergänzen.

In Abhängigkeit vom Anwendungsfall bzw. von der Struktur des Mehrschichtelementes kann das Klebermaterial in den ersten Bereichen zu Erzeugung der Haftzonen partiell nach einem vorgegebenen Muster aufgetragen werden, welches ein oder mehrere vorgegebene Bedingungen erfüllt. Das Muster kann beispielsweise ein regelmäßiges oder unregelmäßiges Punktemuster enthalten oder durch ein solches gebildet sein. Die in Draufsicht erscheinende Form der Punkte bzw. der fertigen Haftzonen kann beispielsweise kreisrund oder oval sein, gegebenenfalls auch polygonal, beispielsweise rechteckförmig oder quadratisch. Auch irreguläre Formen, die sich z.B. durch Verlaufen eines Klebetropfens ergeben können, sind möglich.

Es ist auch möglich, dass das Muster ein regelmäßiges oder unregelmäßiges Linienmuster enthält oder durch ein solches gebildet ist. Bei den Linien kann es sich um gerade Linien oder um einfach oder mehrfach geschwungene Linien handeln. Auch eine Mischung von Punktemustern und Linienmustern ist möglich.

Die räumliche Dichte von Musterelementen (z.B. Punkte und/oder Linien) kann innerhalb der ersten Bereiche im Wesentlichen gleichmäßig sein, sie kann aber auch räumlich variieren, so dass Bereiche mit größerer Dichte von Haftzonen bzw. größerem Flächenanteil von Haftzonen neben Bereichen mit geringerem Flächenanteil von Haftzonen vorliegen. Damit kann auch eine ungleichmäßige räumliche Verteilung der Haftkräfte innerhalb der ersten Bereiche erzeugt werden, falls dies gewünscht ist.

Bei manchen Varianten wird die Kleberschicht in einigen oder allen ersten Bereichen so aufgebracht, dass im Bereich von Randzonen der ersten Bereiche dem Randverlauf angepasste linienförmige Haftzonen erzeugt werden, die normalerweise in Randverlaufsrichtung über größere Strecken ununterbrochen sind. Die Länge einer linienförmigen Haftzonen beträgt typischerweise ein Vielfaches der Breite der linienförmigen Haftzone. Im Inneren, d.h. weiter entfernt von den Randzonen, kann ein Punktemuster oder Linienmuster vorliegen. Durch derartige linienförmige Haftzonen am Rande erster Bereiche kann ein unbeabsichtigtes Ablösen der Leiterfolie in den Randzonen der ersten Bereiche zuverlässig vermieden oder erschwert werden.

Zur Erzeugung einer lateral strukturierten Kleberschicht kann z.B. ein Strahldruckverfahren analog dem Tintenstrahldruck (ink-jet-Druck) eingesetzt werden. Dieses digitale Druckverfahren bietet hohe Flexibilität bei der Gestaltung des aufzubringenden lateral strukturierenden Klebermusters und kann besonders bei Verwendung niedrigviskoser Kleber genutzt werden. Kleber können gegebenenfalls hierzu verdünnt werden. Ein Klebstoffmuster kann auch durch ein Flexodruckverfahren aufgebracht werden, also durch ein Rollenrotationsdruckverfahren, bei dem eine flexible Druckplatte mit erhabenem Muster zum Kleberauftrag verwendet werden kann. Die flexible Stempelrolle rollt auf dem Bedruckstoff (Substrat oder Leiterfolie) ab und erzeugt dabei das gewünschte Klebermuster. Diese Verfahrensvariante des Kleberauftrags kann besonders bei Serien mit sehr großen Stückzahlen wirtschaftlich vorteilhaft sein. Alternativ kann der Kleber auch durch ein Siebdruckverfahren oder ein Offsetdruckverfahren mit geeigneter lateraler Verteilung aufgebracht werden, gegebenenfalls auch durch Slot-Dye-Coating oder durch Tiefdruckverfahren, z.B. Gravure printing.

Eine besonders hohe Flexibilität der Verfahrensführung ist bei manchen Ausführungsformen dadurch gegeben, dass eine lateral strukturierte Multi-Kleberschicht erzeugt wird, die im Bereich erster Haftzonen aus einem ersten Klebermaterial und im Bereich davon gesonderter zweiter Haftzonen aus einem zweiten Klebermaterial besteht, welches sich vom ersten Klebermaterial unterscheidet. Die Klebermaterialien können sich beispielsweise hinsichtlich ihrer Haftfähigkeit am Substrat und/oder an der Leiterfolie und/oder hinsichtlich ihrer Sprödigkeit im ausgehärteten Zustand und/oder ihrem Schrumpfverhalten beim Aushärten unterscheiden.

Vorteile können sich auch dann ergeben, wenn bestimmte Bereiche des Mehrschichtelements als Kontaktierungsbereiche zur späteren Anbringung von elektronischen Komponenten, wie beispielsweise Halbleiterchips, genutzt werden sollen. In diesen Bereichen ist häufig eine erhöhte Temperaturstabilität des Klebermaterials erforderlich, damit das Klebermaterial bei nachfolgenden Kontaktierungsoperationen mittels Löten, Bonden etc. nicht versagt. Geeignete temperaturbeständige Klebermaterialien sind in der Regel teurer als Klebermaterialien, die nicht für höhere Temperaturen ausgelegt sein müssen. Durch Verwendung von zwei oder mehr unterschiedlichen Klebermaterialien bei der Erzeugung der Kleberschicht können ohne Einschränkungen bei der Funktionalität der Mehrschichtelemente die Herstellungskosten günstig gehalten werden.

Um unterschiedliche Klebermaterialien in einem kontinuierlichen Prozess aufbringen zu können, weisen die Einrichtungen zum Verbinden der Leiterfolien mit dem Substrat bei bevorzugten Weiterbildungen eine erste Kleberauftragseinrichtung zum Auftragen eines ersten Klebermaterials zur Erzeugung erster Haftzonen und mindestens eine zweite Kleberauftragseinrichtung zum Auftragen eines zweiten Klebers zur Erzeugung davon gesonderter zweiter Haftzonen auf. Die ersten und zweiten Haftzonen können sich dann zu dem gewünschten Gesamtmuster ergänzen. Durch die Bereitstellung von zwei oder mehr Kleberauftragseinrichtungen werden sich die Anlagekosten in der Regel erhöhen. Insbesondere bei der Herstellung großer Stückzahlen von Mehrschichtelementen, wie es beispielsweise im Bereich der Herstellung von RFID-Antennen üblich ist, können sich diese zusätzlichen Investitionskosten durch Einsparungen bei den Kosten für Klebermaterialien schnell amortisieren. Zusätzlich eröffnet sich die Möglichkeit, lateral strukturierte Kleberschichten zu erzeugen, die zwei oder mehr lateral versetzte Bereiche mit unterschiedlichen Klebermaterialien haben, wodurch die Eigenschaften der Kleberschicht noch besser an die Anforderungen angepasst werden können.

Für die Strukturierung der Leiterfolie können unterschiedliche Trennverfahren bzw. Schneidverfahren genutzt werden, beispielsweise Stanzverfahren oder mechanische Schneidverfahren. Vorzugsweise erfolgt das Strukturieren der Leiterfolien durch Einstrahlen von Laserstrahlung entlang der Grenzen der ersten Bereiche, durch ein Verfahren der Laserbearbeitung. In solchen Fällen umfasst das System ein entsprechendes Laserbearbeitungssystem. Es kann sich z.B. um ein Scannersystem oder ein Maskenprojektionssystem handeln.

Beim Schneiden der Leiterfolie entlang von Grenzen der ersten Bereiche wird das Laserbearbeitungssystem normalerweise in einem ersten Betriebsmodus betrieben, in welchem der Laserstrahl so fokussiert ist, dass der Fokusbereich beim Auftreffen auf die Leiterfolie einen relativ geringen Durchmesser im Bereich von beispielsweise 10 µm bis 150 µm hat. Hierdurch kann die Kontur der leitenden Bereiche des fertigen Mehrschichtelements besonders präzise vorgegeben werden. Außerdem soll hier mit Hilfe des Laserstrahls in der Regel nur die Leiterfolie durchgetrennt werden, so dass sich größere zusammenhängende Folienstücke bilden, die dann in einer nachgeschalteten Reinigungsoperation abgelöst werden können.

Mit Hilfe eines Laserbearbeitungssystems ist es jedoch prinzipiell auch möglich, breitere Schnitte auszuführen und/oder größere zusammenhängende Bereiche durch Abscannen sukzessive vollflächig abzutragen und/oder in gewissen Bereichen sowohl die Leiterfolie als auch das darunter liegende Klebermaterial zu verdampfen. Hierfür ist das Laserbearbeitungssystem bevorzugter Ausführungsformen so ausgelegt, dass es zwischen einem ersten Betriebsmodus (zum Abfahren der Grenzen der ersten Bereiche) und mindestens einem zweiten Betriebsmodus umgestellt werden kann, um andere Bereiche unter anderen Einstrahlbedingungen zu bearbeiten. Zur Änderung des Betriebsmodus kann beispielsweise durch Umschalten in ein anderes optisches Set-up die Fokuseinstellung geändert werden. Zur Anpassung der Energiedichte im Fokusbereich ist es dann in der Regel sinnvoll, die Leistung und/oder die Repetitionsrate der Laserquelle umzustellen. Ein umstellbares Laserbearbeitungssystem kann die Flexibilität bei der Strukturierung der Leiterfolie verbessern.

Es wäre auch möglich, zusätzlich zu einem ersten Laserbearbeitungssystem mindestens ein zweites Laserbearbeitungssystem bereitzustellen, welches zeitgleich mit dem ersten Laserbearbeitungssystem oder zeitlich danach andere zu strukturierende Bereiche bearbeitet als das erste Laserbearbeitungssystem.

Die Erfindung betrifft auch ein zur Durchführung des Verfahrens konfiguriertes System und ein mit Hilfe des Verfahrens hergestelltes oder herstellbares Mehrschichtelement.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können. Ausführungsbeispiele der Erfindung sind in den Zeichnungen dargestellt und werden im Folgenden näher erläutert.

### KURZBESCHREIBUNG DER ZEICHNUNGEN

Fig. 1 zeigt in 1A eine schematische Ansicht eines ersten Teilsystem einer Ausführungsform eines Systems zum Herstellen von laminierten Mehrschichtelementen, in 1B eine Draufsicht auf ein partiell mit Kleber beschichtetes Substrat und in 1C einen Schnitt durch ein Laminat;
Fig. 2 zeigt in 2A eine schematische Ansicht eines zweiten Teilsystem des Systems und 2B einen Schnitt durch ein mittels Laserbearbeitung strukturiertes Laminat;
Fig. 3 zeigt ein Beispiel für ein Layout einer nach dem Verfahren hestellbaren RFID-Antenne und in 3B einen vergrößerten Ausschnitt des Kontaktierungsbereichs der Antenne aus 3A mit Haftzonen aus unterschiedlichen Klebermaterialien;
Fig. 4 zeigt in 4A bis 4E veschiedene raumliche Verteilung von Haftzonen in partiell mit Kleber beschichteten ersten Bereichen;
Fig. 5 zeigt die Laserbearbeitung in einem kleinen zweiten Bereich mit Leiterbahnen und engen Linienabständen; und
Fig. 6 zeigt eine Draufsicht auf eine Ausführungsform, bei der lateral ausgedehnte zweite Bereiche mit geringem Bedeckungsgrad von Haftzonen neben ersten Bereichen mit einem hohen Bedeckungsgrad von Haftzonen vorliegen.

### DETAILLIERTE BESCHREIBUNG BEVORZUGTER AUSFÜHRUNGSBEISPIELE

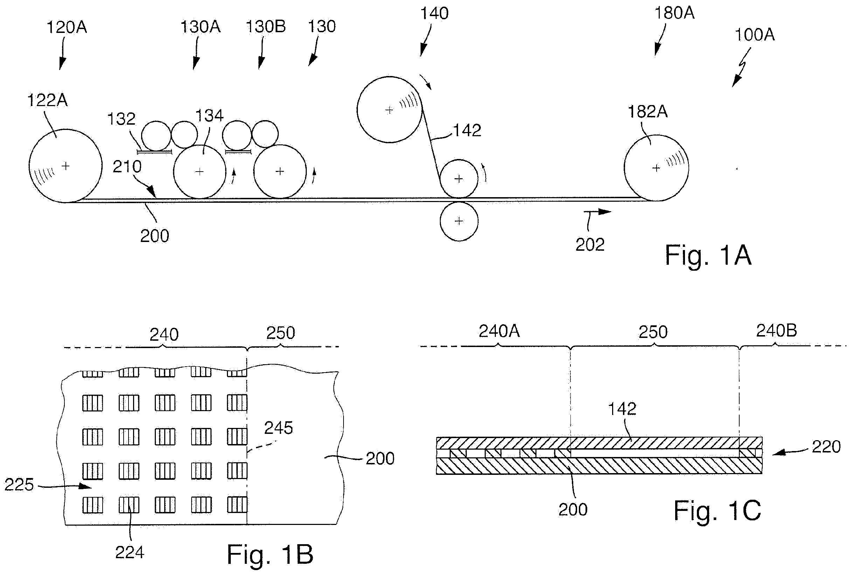

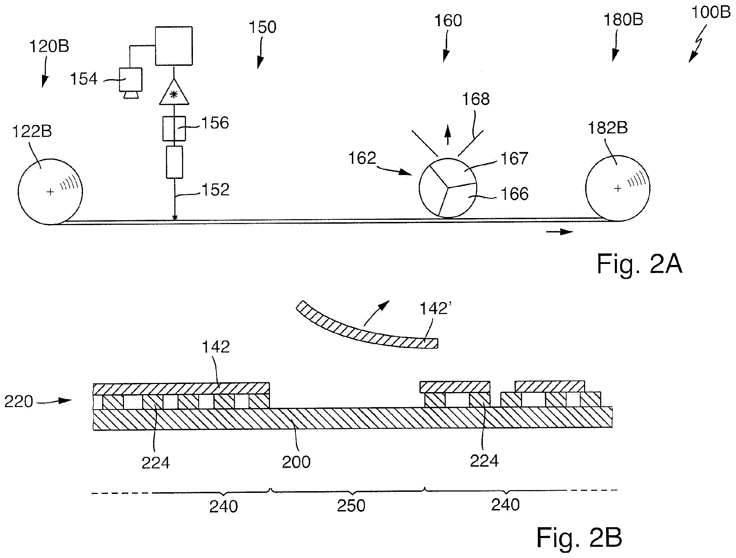

In Fig. 1A ist ein erstes Teilsystem 100A einer Ausführungsform eines Systems zum Herstellen von laminierten Mehrschichtelementen auf flexiblen bandförmigen Substraten in einem Rolle-zu-Rolle-Verfahren gezeigt. Das erste Teilsystem enthält Einrichtungen zur Herstellung eines Laminats. Figur 2A zeigt ein zugehöriges zweites Teilsystem 100B des Systems, welches an einem im ersten Teilsystem hergestellten Laminat nachgeschaltete Prozessschritte (z.B. Strukturierung und Reinigung) ausführt. Die beiden Teilsysteme sind voneinander unabhängig betriebsfähig und können räumlich getrennt voneinander aufgestellt sein, z.B. in unterschiedlichen Räumen eines Betriebs oder sogar an unterschiedlichen Standorten des gleichen Unternehmens oder unterschiedlicher Unternehmen.

Das System (Gesamtsystem), welches das erste und zweite Teilsystem enthält, ist für die Herstellung von Antennen für Radiofrequenz-Identifikationssysteme (RFID-Antennen) konfiguriert, kann jedoch auch zur Herstellung anderer mittels Laminierung herstellbarer Mehrschichtelemente mit leitfähigen Strukturen, z.B. für elektrische Schaltungen auf flexiblen (biegsamen) Substraten, verwendet werden. Beispielsweise können bei entsprechender Konfiguration auch mehrseitige flexible Leiterplatten, Kondensatoren, Elektroden von gedruckten Batterien, Sensoren, z.B. Dehnmessstreifen, oder Aktoren hergestellt werden.

Das modular aufgebaute System verarbeitet im Beispielsfall in einer unterteilten Fertigungslinie ein flexibles Substrat 200, das in Form eines langen flachen Bandes vorliegt und beispielsweise durch eine Kunststofffolie oder eine Papierbahn gebildet sein kann. In speziellen Anwendungsfällen sind auch andere Nichtleiter oder Folien aus Metall oder mit Metallschichten als Substrat verwendbar.

Das frische, noch unbearbeitete Substratmaterial wird von einer aktiv angetriebenen Vorratsrolle 122A des ersten Teilsystems 100A abgerollt, welche sich in einer Abwickeleinrichtung 120A an der Eingangsseite des ersten Teilsystems 100A befindet. Von dort wird das Substrat durch verschiedene Einrichtungen bzw. Module des ersten Teilsystems hindurch in Transportrichtung 202 kontinuierlich bis zu einer Aufwickelrolle 182A gefördert, die sich in einer Aufwickeleinrichtung 180A am Ende des ersten Teilsystems 100A befindet. Mit Hilfe der Einrichtungen bzw. Module des ersten Teilsystems wird mittels einer lateral strukturierten Kleberschicht eine Leiterfolie auf das Substrat laminiert.

Eine Kleberauftrageinrichtung 130 ist dafür konfiguriert, auf der Oberseite 210 des durchlaufenden, noch unbehandelten Substrats über eine vorgegebene Arbeitsbreite, die in der Regel kleiner ist als die Bandbreite des Substrats, eine dünne Kleberschicht aufzubringen. In einer nachgeschalteten Laminiereinrichtung 140 wird ein Leiterfolie 142, beispielsweise eine Aluminiumfolie oder eine andere Metallfolie, auf die Kleberschicht unter Druck aufgebracht, so dass die Leiterfolie mit dem Substrat durch die zwischenliegende Kleberschicht verbunden wird. Dadurch entsteht ein Laminat.

Das resultierende, noch unstrukturierte Laminat wird auf die Aufwickelrolle 182A aufgewickelt. Diese wird dann, ggf. nach einer Zwischenlagerung, als Vorratsrolle 122B des zweiten Teilsystems 100B (Fig. 2A) verwendet. Mit Hilfe der Einrichtungen bzw. Module des zweiten Teilsystems 100B wird das Laminat strukturiert und gereinigt.

In einer Laserbearbeitungseinrichtung 150 wird die auflaminierte Metallfolie (Leiterfolie) des von der Vorratsrolle 122B der Abwickeleinrichtung 120B abgerollten Laminats lateral strukturiert, indem die Leiterfolie an den Grenzen derjenigen Bereiche, die die gewünschte Leiterstruktur der fertigen RFID-Antenne bilden sollen, mittels eines Laserstrahl durchtrennt wird. Dabei entstehen je nach Layout der Leiterstruktur mehr oder wenige große Folienstücke der Metallfolie, die nicht zum gewünschten Endprodukt gehören und deshalb entfernt werden müssen. Es können auch noch andere Strukturierungsoperationen mittels Laser durchgeführt werden.

Zum Reinigen, d.h. zum Entfernen der Folienstücke, ist eine nachgeschaltete Reinigungseinrichtung 160 vorgesehen, die im Beispielsfall eine mittels Unterdruck und Überdruck arbeitende Reinigungswalze 162 und eine Absaugeinrichtung 168 aufweist.

Das resultierende, strukturierte und gereinigte Laminat wird auf die Aufwickelrolle 182B der Aufwickeleinrichtung 180B aufgewickelt.

Die Kleberauftrageinrichtung 130 ist so konfiguriert, dass eine lateral strukturierte Kleberschicht mit beschichteten Bereichen und unbeschichteten Bereichen auf die Oberseite 210 des Substrats aufgebracht werden kann. Hierzu hat die Kleberauftrageinrichtung ein für den Flexodruck eingerichtetes erstes Druckwerk, bei dem Kleberflüssigkeit von einem Klebervorrat 132 über ein Walzenwerk auf einen Druckformzylinder 134 übertragen wird, der eine flexible Druckplatte mit erhabenen Strukturen trägt, die den Kleber auf die Substratoberseite überträgt.

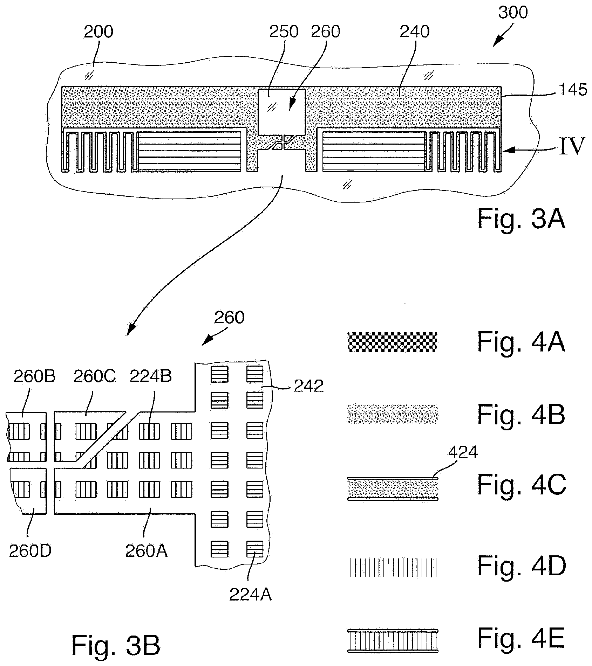

Das System ist zur Herstellung von Mehrschichtelementen in Form von RFID-Antennen konfiguriert. Fig. 3A zeigt beispielhaft in Draufsicht die Leiterstruktur einer Ausführungsform einer RFID-Antenne 300 nach der Strukturierungsoperation. Die auf das Substrat 200 auflaminierte Leiterstruktur 145 erscheint dunkel. Diejenigen Bereiche, in denen die Leiterstruktur am fertigen Produkt verbleibt, werden hier als erste Bereiche 240 bezeichnet. Diejenigen benachbart zu den ersten Bereichen liegenden Bereiche, die im fertigen Produkt elektrisch nicht leitend sein sollen und die in Fig. 3A hell erscheinen, werden als zweite Bereiche 250 bezeichnet. Die zweiten Bereiche können nochmals unterteilt werden in relativ schmale zweite Bereiche, die insbesondere zwischen parallel zueinender verlaufenden Leiterbahnen der Leiterstruktur liegen, und lateral ausgedehnte zweite Bereiche, deren Ausdehnung typischerweise vielfach größer ist als die Breite von Leiterbahnen oder die Breite von schmalen, zwischen den Leiterbahnen liegenden Bereichen.

Die links und rechts der Mitte liegenden generell rechteckförmigen Bereiche dienen als Antennenelemente. In der Mitte zwischen den Antennenelementen liegt ein Kontaktierungsbereich 260, der auch als "pad area" bezeichnet wird und dazu dient, einen RFID-Chip mit der metallischen Antennenstruktur durch Löten, Bonden oder dergleichen elektrisch zu kontaktieren. Ein Ausschnitt des Kontaktierungsbereichs 260 ist in der Fig. 3B vergrößert dargestellt. Der Kontaktierungsbereich hat vier durch schmale leiterfreie Bahnen elektrisch getrennte Abschnitte 260A bis 260D, von denen die Abschnitte 260A und 260B direkt in die daran anschließenden Antennenabschnitte 242 übergehen. Die RFID-Antenne mit dem damit verbundenen RFID-Chip bildet einen Transponder eines RFID-Systems, der z.B. an oder in einem Gegenstand zu dessen Identifizierung angebracht werden kann und einen den Gegenstand kennzeichnenden Code enthält, der über ein externes Lesegerät drahtlos ausgelesen werden kann.

Bei der Herstellung dieser RFID-Antenne wird die Leiterfolie, die später die elektrisch leitenden Bereiche bilden soll, mit Hilfe einer lateral strukturierten Kleberschicht 220 am Substrat befestigt. Der Begriff "lateral strukturiert" bedeutet hierbei, dass die Kleberschicht in Lateralrichtung, also in Richtung der Schichtausdehnung, nicht vollflächig oder ununterbrochen, sondern mehrfach unterbrochen ist, so dass nur ein Teil der Oberfläche des Substrats mit Klebermaterial bedeckt wird (partieller Kleberauftrag). Dabei wird mit Hilfe der Kleberauftragseinrichtung 130 nur in den ersten Bereichen 240 Klebermaterial (Klebstoff) aufgebracht, während in den lateral ausgedehnten zweiten Bereiche 250, die im fertigen Produkt nicht elektrisch leitend sein sollen, kein Kleber aufgebracht wird.

Figur 1B zeigt beispielhaft den Bereich einer Grenze 245 zwischen einem ersten Bereich 240 und einem zweiten Bereich 250. Innerhalb des ersten Bereichs 240 wird der Kleber jedoch nicht vollflächig aufgetragen. Vielmehr wird der Kleber nur punktuell aufgebracht, um ein gerastertes Muster relativ kleiner Haftzonen 224 zu bilden, zwischen denen in Lateralrichtung kleberfreie Zwischenräume 225 verbleiben. Das Flächenverhältnis zwischen der Gesamtfläche aller Haftzonen einer Einheitsfläche eines ersten Bereichs zur Gesamtfläche dieser Einheitsfläche wird hier auch als "Bedeckungsgrad" bezeichnet, so dass ein Bedeckungsgrad von 100% einem vollflächigen Kleberauftrag entspricht. Bedeckungsgrade innerhalb der ersten Bereiche können je nach Anwendungsfall und Anforderung an die Haftkraft zwischen nahezu vollflächigem Kleberauftrag (beispielsweise Bedeckungsgrad 90%) und 10% Bedeckungsgrad liegen, gegebenenfalls auch darunter, beispielsweise bis zu 5% Bedeckungsgrad. Häufig liegt der Bedeckungsgrad im Bereich zwischen 20% und 80%. Neben dem Bedeckungsgrad können auch die Form und Größe der Haftzonen sowie deren laterale Verteilung innerhalb der ersten Bereiche den Anforderungen angepasst werden. Weitere Beispiele werden in Zusammenhang mit den Fig. 3 und 4 noch näher erläutert.

Bei einem Herstellungsverfahren kann z.B. ein drucksensitiver Kleber (pressure sensitive adhesive, PSA) verwendet werden, der nach dem Kleberauftrag durch Druck unter Einstrahlung von UV-Strahlung noch aktiviert wird. Auch die Verwendung thermisch aktivierbarer Kleber ist möglich. Die Dicke der Kleberschicht kann beispielsweise zwischen 1 µm und 50 µm, insbesondere im Bereich zwischen 5 µm und 20 µm liegen. Die Dicke der Leiterfolie ist typischerweise geringer als diejenige der Kleberschicht und kann beispielsweise zwischen 5 µm und 100 µm liegen, insbesondere im Bereich zwischen 5 µm und 40 µm. Im Beispielsfall einer RFID-Antenne kann die Breite der Leitermaterialbahnen beispielsweise zwischen 0,1 mm und 30 mm, insbesondere zwischen 0,5 mm und 20 mm liegen. Der laterale Abstand benachbarter Haftzonen kann in der gleichen Größenordnung liegen, ist jedoch häufig größer als die Leitermaterialbahnbreite.

Nach dem Kleberauftrag und einer eventuell nachgeschalteten Nachbehandlung wird in der Laminiereinrichtung 140 die Leiterfolie 142 in einem kontinuierlichen Prozess auf die Kleberschicht aufgebracht und auf diese Weise vermittelt über die lateral strukturierte Kleberschicht mit dem Substrat 200 verbunden. Fig. 1C zeigt einen senkrechten Schnitt durch einen Ausschnitt eines so entstandenen Laminats. In den ersten Bereichen 240 haftet die Leiterfolie 142 im Bereich der lateral mit Abstand zueinander liegenden Haftzonen 224 am Substrat, während die schmalen kleberfreien Zwischenbereiche 225 durch die Leiterfolie überbrückt werden. In den lateral ausgedehnten zweiten Bereichen 250 besteht kein Haftkontakt zwischen Leiterfolie und Substrat, so dass die Leiterfolie zwischen lateral benachbarten ersten Bereichen 240A, 240B frei über das Substrat gespannt ist und je nach Ausdehnung des zweiten Bereiches und Dicke der Kleberschicht auch auf dem Substrat partiell aufliegen kann.

Das fertige Laminat ist ein Zwischenprodukt, das auf die Aufwickelrolle 182A am Ende des ersten Teilsystems 100A aufgewickelt und für die Weiterverarbeitung abtransportiert werden kann.

Die Weiterverarbeitung erfolgt im Beispielsfall im zweiten Teilsystem 100B. Eine aus dem ersten Teilsystem 100A entnommene Aufwickelrolle mit Laminat wird hier in der Abwickeleinrichtung 120B als Vorratsrolle 122B verwendet. Das von der Vorratsrolle 122B abgerollte und kontinuierlich in Transportrichtung 202 geförderte Laminat wird mit Hilfe der Laserbearbeitungseinrichtung bzw. eines Laserbearbeitungssystems 150 strukturiert, um in der Leiterfolie die gewünschte Zielkontur, nämlich die angestrebte Leiterstruktur, zu erzeugen. Die Laserbearbeitungseinrichtung 150 ist im Beispielsfall als Laserscanner konfiguriert und erzeugt einen fokussierten Laserstrahl 152, der als Trennwerkzeug dient und mittels einer Scaneinrichtung entlang der Grenzen der zu erzeugenden Leiterstruktur entlang geführt wird. Typische Schnittbreiten bei fokussiertem Laserstrahl können bei dieser Schneidoperation im Bereich zwischen 1 µm und 250 µm liegen, insbesondere im Bereich zwischen 10 µm und 100 µm. Die Laserleistung ist dabei so eingestellt, dass das Material der Leiterfolie verdampft wird, ohne dass das darunter liegende Substrat angegriffen wird. Die Kleberschicht kann teilweise oder vollständig verdampft werden, sie kann aber auch verbleiben. Das Laserbearbeitungssystem 150 umfasst im Beispielsfall mindestens eine Kamera 154, mit der die Laserbearbeitungsoperation überwacht werden kann. Korrekturen bei der Steuerung der Laserbearbeitung können auf Basis von Bilddaten der Kamera vorgenommen werden. Im Beispielsfall ist die Kamera der Laserbearbeitungseinheit vorgeschaltet und beobachtet die Substratbahn bzw. Laminatbahn vor Einlauf in den Bearbeitungsbereich (Scannerbereich) des Lasersystems. Dadurch ist es möglich, anhand spezieller Markierungen am Rand der Substratbahn den Scannerbereich zu positionieren. Diese Ausrichtung ist für die Erzielung höchster Lagegenauigkeit der Schnitte vorgesehen, da sich die durchlaufende Laminatbahn in der Regel in Transversalrichtung um bis zu 1 mm oder mehr hin und her bewegen kann, während die gewünschte Positioniergenauigkeit bei den Schitten wesenlich geringer ist und z.B. im Bereich von 10 µm bis 50µm liegen kann.

Fig. 2B zeigt einen Vertikalschnitt durch einen Ausschnitt des mittels Laser strukturierten Laminats. Nachdem der Laserstrahl die Metallfolie an den gewünschten Grenzen der ersten Bereiche vollständig durchtrennt hat, ergeben sich in lateral ausgedehnten zweiten Bereichen größere zusammenhängende Folienstücke 142', die nicht mehr mit der aufgeklebten Leiterfolie zusammenhängen und leicht abgelöst werden können. In den ersten Bereichen, wo eine elektrische Leiterstruktur erwünscht ist, haftet die Leiterfolie vermittelt über die strukturierte Kleberschicht im Bereich der Haftzonen 224 fest am Substrat 200. Wie im linken Teil von Fig. 2B erkennbar, kann der Laserschnitt exakt an der Grenze zwischen einem mit Klebermaterial partiell beschichteten Flächenbereich und dem kleberfreien zweiten Bereich erfolgen, so dass der Rand der Leiterfolie bündig mit Rändern von Haftzonen ist. Im rechten Teil der Figur ist angedeutet, dass dies jedoch nicht zwingend ist. Es ist auch möglich, dass die Leiterfolie mit ihrem Rand über darunter liegende Haftzonen hinaus steht oder dass einzelne Haftzonen unterhalb des geschnittenen Randes der Leiterfolie hervorstehen.

Nach der Laserstrukturierungsoperation verbleiben größere zusammenhängende Folienstücke 142' aus den zweiten Bereichen zunächst lose am Substrat. Sie werden später mit Hilfe der nachgeschalteten Reinigungseinrichtung 160 schonend vom Substrat entfernt. Als Reinigungseinrichtung kann beispielsweise eine Absauganlage verwendet werden, die ausschließlich mittels Luftstrom bzw. Unterdruck die losen Folienstücke absaugt. Im Beispielsfall weist die Reinigungseinrichtung eine mittels Unterdruck und Überdruck arbeitende Reinigungswalze 162 auf. Die Reinigungswalze hat eine gasdurchlässige Außenwalze und einen Walzenkern mit einer Unterdruckkammer 166 und einer Überdruckkammer 167, um in einem Ansaugabschnitt (nahe am Substrat im Bereich der Unterdruckkammer) Folienstücke durch Unterdruck anzusaugen, in einen Freigabeabschnitt (entfernt vom Substrat im Bereich der Überdruckkammer) zu fördern und dort mittels Überdruck freizugeben. Die freigegebenen Folienstücke werden mittels einer Absaugeinrichtung 168 mittels eines Luftstroms weggefördert.

Das so gereinigte Band mit Mehrschichtelementen wird in der Aufwickeleinrichtung 180B auf die Aufwickelrolle 182B aufgewickelt und kann dann in Rollenform zur Weiterverarbeitung (z.B. Vereinzelung) transportiert werden.

Der partielle Kleberauftrag in den ersten Bereichen kann im Hinblick auf viele unterschiedliche Parameter an die jeweiligen Anforderungen angepasst werden. Insbesondere kann die räumliche Verteilung von Haftzonen bzw. Haftinseln in Lateralrichtung sowie die Größe der Haftzonen und deren Form in weiten Grenzen variiert werden. In den Fig. 4A bis 4E sind beispielhaft einige Varianten eines partiellen Kleberauftrags dargestellt, die beispielsweise in den geraden Abschnitten IV der mäanderförmig verlaufenden Leiterbereiche der RFID-Antenne aus Fig. 3A oder an anderer Stelle vorgesehen sein können.

Fig. 4A zeigt ein Beispiel, bei dem die dunkel dargestellten Haftzonen quadratische Form haben und sich nach Art eines Schachbrettmusters mit den hell erscheinenden kleberfreien Zwischenbereichen abwechseln. Dadurch wird ein Bedeckungsgrad von ca. 50% erreicht, wobei die Dichte der Haftzonen über die gesamte Breite inklusive der Randzonen konstant ist.

Bei der Variante von Fig. 4B liegen polygonale oder runde Haftzonen in einer stochastischen Verteilung vor, wobei die Flächendichte bzw. der Bedeckungsgrad über die gesamte gezeigte Breite etwa konstant ist. Der Bedeckungsgrad liegt in der Regel zwischen 10% und 90%, hier bei etwa 50%.

Fig. 4D zeigt ein Beispiel, bei dem die Haftzonen in Form von parallel zueinander verlaufenden Linien vorliegen, zwischen denen Zwischenbereiche verbleiben, deren Breite größer ist als die Linienbreite der Haftzonen. Bei dieser Schraffurstruktur kann der Bedeckungsgrad z.B. zwischen ca. 20% bis 95% liegen (hier bei etwa 30%) und kann durch Variation von Linienbreiten und/oder Linienabständen variiert werden.

Fig. 4C zeigt eine Variante der in Fig. 4B gezeigten Verteilung, wobei in den seitlichen Randzonen des streifenförmigen ersten Bereiches der Kleber eine lange linienförmige Haftzone 424 bildet, die der Kontur des Randes des ersten Bereiches folgt. Durch diese Ausgestaltung wird die Haftung zwischen aufgeklebten Leiterfolien und dem Substrat am Rande der am Substrat verbleibenden ersten Bereiche verstärkt, so dass ein Ablösen dieser Randbereiche nach dem Laserstrukturieren noch zuverlässiger als bei Varianten ohne Randzonenverstärkung vermieden wird und zusätzlich eine seitliche Abdichtung der nur teilweise mit Kleber belegten ersten Bereiche geschaffen wird. Die Fig. 4E zeigt eine entsprechende Verstärkung der Randzonen bei einem Kleberauftrag mit Schraffurstruktur. Die Varianten der Fig. 4C und 4E können auch so beschrieben werden, dass der Bedeckungsgrad entlang der Außenkontur 100% beträgt und im Inneren der ersten Bereiche, also zwischen den Randbereichen, einen deutlich niedrigeren Wert hat, der beispielsweise zwischen 20% und 60% liegt.

Entsprechende Kleberverteilungen können nicht nur in den mäanderförmigen Bereichen der RFID-Antenne vorliegen, sondern auch in anderen Bereichen, beispielsweise in den daneben liegenden deutlich größeren zusammenhängenden Folienbereichen. Es ist auch möglich, dass innerhalb der ersten Bereiche zwei oder mehr Zonen mit unterschiedlichen Haftzonenverteilungen existieren. Beispielsweise können die in Fig. 4 gezeigten Verteilungen nur in den relativ schmalen mäanderförmigen Bereichen vorliegen, während in den benachbarten größeren zusammenhängenden Bereichen eine geringere Flächendichte von Haftzonen bzw. ein geringer Bedeckungsgrad vorgesehen sein kann.

Es gibt eine Vielzahl von Anwendungsfällen, bei denen ein einziges Klebermaterial ausreicht, um alle Haftzonen des Laminats zu erzeugen. In diesem Fall ist es ausreichend, wenn eine einzige Kleberauftragseinrichtung vorgesehen ist, die z.B. für Flexodruck oder Ink-Jet-Verfahren geeignet ist und den Kleber in allen gewünschten Bereichen aufträgt. Bei dem Ausführungsbeispiel mit dem ersten Teilsystem 100A ist zusätzlich zu einer ersten Kleberauftragseinrichtung 130A eine unmittelbar nachgeschaltete zweite Kleberauftragseinrichtung 130B vorgesehen. Hierdurch wird die Möglichkeit geschaffen, zwischen dem Abrollen des Substrats von der Vorratsrolle 122A und dem Auflaminieren der Leiterfolie 142 zwei unterschiedliche Klebermaterialien aufzubringen, normalerweise in unterschiedlichen Bereichen des Substrats. Im Beispielsfall ist die erste Kleberauftragseinrichtung 130A dafür eingerichtet, in allen ersten Bereichen mit Ausnahme des Kontaktierungsbereichs 260 erste Haftzonen aus einem ersten Klebermaterial aufzubringen. Die vier Abschnitte 260A bis 260D innerhalb des Kontaktbereichs werden durch die erste Kleberauftragseinrichtung nicht beschichtet. Die zweite Kleberauftragseinrichtung 130B ist dafür eingerichtet, ausschließlich die Abschnitte 260A bis 260D des Kontaktierungsbereichs 260 mittels eines zweiten Klebermaterials zu beschichten, welches höhere Temperaturbeständigkeit aufweist als das erste Klebermaterial. Klebermaterialien bzw. Kombinationen unterschiedlicher Klebermaterialien können nach unterschiedlichen Kriterien ausgewählt werden, z.B. Temperaturbeständigkeit, Sprödigkeit im ausgehärteten Zustand und/oder Schrumpfungsgrad beim Aushärten.

Auch das zweite Klebermaterial wird nur partiell in Form von zweiten Haftzonen 224B aufgetragen. Durch den zweistufigen Kleberauftrag entsteht eine lateral strukturierte Multi-Kleberschicht, bei der die temperaturbeständigeren zweiten Haftzonen innerhalb des Kontaktierungsbereichs 260 die Leiterfolie auch dann fest am Substrat halten, wenn in einer nachgeschalteten Bestückungsoperation ein RFID-Chip oder ein anderes Bauelement unter Einwirkung von Temperatur auf die Kontaktabschnitte 260A bis 260D durch Löten, Bonden oder auf andere Weise aufgebracht wird.

Es wäre auch möglich, den relativ teuren, temperaturbeständigen zweiten Kleber im Kontaktierungsbereich 260 nicht nur partiell, sondern vollflächig aufzubringen, während in den daran angrenzenden ersten Bereichen der erste Kleber nur partiell aufgebracht wird. Da die Kontaktbereiche nur relativ kleine Flächen haben, ist dies ohne erhebliche Mehrkosten möglich.

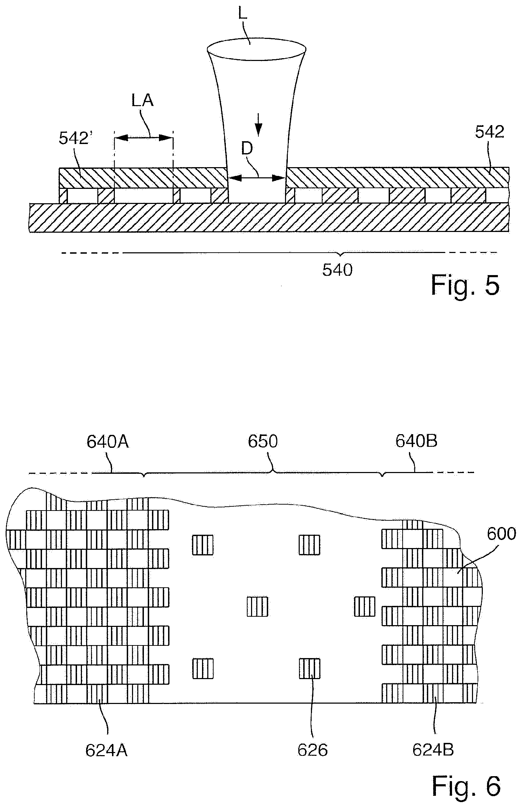

Bei RFID-Antennen oder bei anderen auf Laminatbasis herstellbaren leitfähigen Strukturen kann es erste Bereiche 540 geben, die sich dadurch auszeichnen, dass am fertigen Mehrschichtelement schmale, linienförmige Leiterbahnen 542' mit geringen lateralen Linienabständen LA parallel zueinander verlaufen sollen (vgl. Fig. 5). Die Linienabstände können beispielsweise im Bereich von unterhalb von 300 bis 500 µm liegen. Eine derartige Linienstruktur mit schmalen Linienabständen kann dadurch erzeugt werden, dass das Material der Leiterfolie 542 in den Bereichen zwischen den Leiterbahnen mittels Laserabtrag vollständig verdampft wird. In diesem Fall sehr schmaler, also nicht lateral ausgedehnter zweiter Bereiche bleiben keine Folienrückstände zurück, die später abgereinigt werden müssen. Bei dieser Laserbearbeitungsoperation kann gegebenenfalls auch der darunter liegende Klebstoff der Haftzonen teilweise oder vollständig verdampft werden. Dies ist jedoch nicht zwingend und häufig nicht vorgesehen, so dass am fertigen Produkt zwischen den Leiterbahnen Kleberreste vorliegen können.

Falls das Abtragsprofil des Laserstrahls L bzw. der für den Abtrag wirksame Abtragsdurchmesser D kleiner ist als die gewünschten Linienabstände, können die zweiten Bereiche zwischen den Leiterlinien z.B. mäanderförmig vollflächig abgefahren werden, um breitere Abtragsbereiche zu erreichen. Derartige Operationen sind mit Laserbearbeitungseinrichtungen möglich, bei denen der Laserstrahl auf einen festen Strahldurchmesser im Fokusbereich eingestellt ist.

Es kann jedoch sinnvoll sein, dass Schneiden der Außenkonturen entlang der Grenzen der ersten Bereiche mit einer anderen Laserkonfiguration durchzuführen als das Strukturieren im Bereich von dünnen Linien und schmalen Linienabständen. Um eine Bearbeitung mit anderer Laserkonfiguration durchzuführen, kann beispielsweise vorgesehen sein, zwei unterschiedliche Laser mit gleicher oder unterschiedlicher Wellenlänge und/oder unterschiedlicher Pulsdauer zu nutzen. Hierzu kann eine zweite Laserbearbeitungsvorrichtung vor oder hinter einer ersten Laserbearbeitungseinrichtung angeordnet sein.

Im Beispielsfall ist jedoch das Laserbearbeitungssystem der Laserbearbeitungseinrichtung 150 zwischen unterschiedlichen Betriebsmodi über die Steuerung umschaltbar. Insbesondere ist die Möglichkeit realisiert, den Strahldurchmesser in der Bearbeitungsebene bzw. im Fokusbereich stufenlos zu verändern. Hierzu kann beispielsweise ein variabler Beam-Expander 156 oder ein Fokus-Shifter vorgesehen sein. Dann ist es beispielsweise möglich, beim Abfahren der Grenzen der ersten Bereiche mit einem Fokusdurchmesser im Bereich zwischen 50 µm und 100 µm zu arbeiten, und den Fokusdurchmesser für die Bearbeitung von zweiten Bereichen schmaler Linienabstände auf einen größeren Wert, beispielsweise in der Größenordnung von 300 µm zu vergrö-βern. Der größere Strahldurchmesser kann auch im Scanbetrieb zum Abtragen größerer zusammenhängender Bereiche der Leiterfolie benutzt werden.

Bei den bildlich dargestellten Beispielen im Hinblick auf Ausführungsbeispielen liegt in den ersten Bereichen ein partieller Kleberauftrag mit Haftzonen vor, während die lateral ausgedehnten zweite Bereiche nicht mit Klebermaterial beschichtet werden und auch am fertigen Produkt kleberfrei bleiben. Die von den lateral ausgedehnten zweiten Bereichen gelösten Folienstücke liegen dann nach der Strukturierungsoperation locker auf dem strukturierten Laminat. Falls dies vermieden werden soll, ist es auch möglich, in den lateral ausgedehnten zweiten Bereichen, die am Endprodukt elektrisch nicht leitend sein sollen, einen partiellen Haftkontakt zwischen dem Substrat und der Leiterfolie an einer Vielzahl von über den ausgehnten zweiten Bereich verteilten Haftzonen zu erzeugen. Um dennoch ein zuverlässiges Ablösen der Folienstücke während der Reinigungsoperation sicherzustellen, sollte die Haftkraft in den lateral zweiten ausgedehnten Bereichen im Vergleich zur Haftkraft in den ersten Bereichen deutlich geringer sein. Dies kann beispielsweise dadurch erreicht werden, dass kleinflächige Haftzonen relativ weit auseinander liegen, beispielsweise um einen Bedeckungsgrad von maximal 10% oder maximal 20% zu erreichen. Fig. 6 zeigt hierzu beispielhaft eine schematische Draufsicht auf ein Substrat 600, das zwischen zwei ersten Bereichen 640A und 640B mit einem Schachbrettmuster erster Haftzonen 624A, 624B (Bedeckungsgrad 50%) einen lateral ausgedehnten zweiten Bereich 650 aufweist, in dem vereinzelt kleinere zweite Haftzonen 626 vorliegen, deren laterale Abstände in alle Richtungen um ein Mehrfaches größer sind als die Maximaldurchmesser der Haftzonen. Hierdurch können in den zweiten Bereichen geringe Bedeckungsgrade beispielsweise in der Größenordnung zwischen 5% und 20% erzielt werden.

Bei dieser Variante können eventuelle Probleme, die sich durch undefiniertes Ablösen von nicht benötigten, bereits ausgeschnittenen Folienstücken ergeben, zuverlässig vermieden werden, da die zu entfernenden Folienstücke nach der Laserstrukturierungsoperation noch an den weit verteilten zweiten Haftzonen 626 anhaften, bis sie durch die Reinigungseinrichtung abgelöst werden.

Die Figuren 1A und 2A zeigen nur wenige Einrichtungen des Gesamtsystems. Dieses kann bei der gezeigten und anderen Konfigurationen weitere Einrichtungen bzw. Module aufweisen. Beispielsweise kann zwischen der Abwickeleinrichtung 120A und der Kleberauftrageinrichtung 130 noch eine Vorreinigungseinrichtung zur Reinigung des Substrats unmittelbar vor dem Kleberauftrag vorgesehen sein. Zwischen der Kleberauftrageinrichtung und der Laminiereinrichtung können noch ein oder mehrere Klebernachbehandlungseinrichtungen vorgesehen sein. Beispielsweise kann eine Trocknungseinrichtung vorgesehen sein, um einen nach dem Kleberauftrag noch zu feuchten Kleber vor der Laminierung zu trocknen. Bei Verwendung von Klebern, die erst durch eine Nachbehandlung aktiviert werden, kann eine entsprechende Aktivierungseinheit vorgesehen sein. Bei Verwendung eines durch Ultraviolettstrahlung aktivierbaren Klebers kann beispielsweise eine UV-Strahlungseinheit vorgesehen sein. Nach der Abreinigung der fertig strukturierten Substratbahn können die fertig gestellten Mehrschichtelemente mittels einer Schneideinrichtung vereinzelt werden, welche zwischen der Reinigungseinrichtung 160 und der Aufwickeleinrichtung 182B angeordnet sein kann.

Die Aufteilung des Gesamtsystems in zwei räumlich separate Teilsysteme kann in manchen Konstellationen aus prozesstechnischen Gründen und/oder aus Raumgründen günstig sein, ist aber nicht zwingend. Bei anderen Ausführungsformen entfällt die zwischengeschaltete Aufwicklung, so dass alle Bearbeitungsoperationen in einer durchgehenden Fertigungslinie an der durchlaufenden Substratbahn ohne zwischenzeitliche Aufwicklung erfolgen.

Anstelle eines Rolle-Zu-Rolle-Verfahrens kann auch ein bogenverarbeitendes Verfahren (Sheet-to-Sheet-Verfahren) genutzt werden.

## Patentansprüche

1. Verfahren zum Herstellen eines Mehrschichtelements mit einem Substrat und mindestens einer mit dem Substrat flächig verbundenen Leiterstruktur, die erste Bereiche aus elektrisch leitendem Material aufweist, welches nach einem vorgegebenen Muster vorliegt, wobei zwischen den ersten Bereichen elektrisch nicht leitende zweite Bereiche liegen, insbesondere zum Herstellen von RFID-Antennen oder flexiblen Leiterplatten in einem Rolle-zu-Rolle-Verfahren, **gekennzeichnet durch** die folgenden Schritte:
Verbinden einer Leiterfolie (142) mit dem Substrat (200) mittels einer zwischenliegenden lateral strukturierten Kleberschicht (220) derart, dass in den ersten Bereichen (240) ein partieller Haftkontakt zwischen dem Substrat und der Leiterfolie an einer Vielzahl von Haftzonen (224) derart erzeugt wird, dass zwischen den Haftzonen kleberfreie Zwischenbereiche liegen, die durch die Leiterfolie überbrückt werden, und die Leiterfolie in lateral ausgedehnten zweiten Bereichen (250) nicht oder weniger fest durch Kleber mit dem Substrat verbunden wird;
Strukturieren der Leiterfolie durch Schneiden der Leiterfolie entlang von Grenzen der ersten Bereiche; und
Entfernen zusammenhängender Folienstücke (142') der Leiterfolie (142) aus lateral ausgedehnten zweiten Bereichen (250), wobei Folienstücke in den ersten Bereichen nicht abgelöst, sondern im Bereich der Haftzonen am Substrat (200) festgehalten werden.

2. Verfahren nach Anspruch 1, **dadurch gekennzeichnet, dass** ein Flächenanteil von Kleber zur Erzeugung der Haftzonen (224) innerhalb der ersten Bereiche (240) zwischen 10% und 90% liegt.

3. Verfahren nach Anspruch 1 oder 2, **dadurch gekennzeichnet, dass** in Bereichen, die den lateral ausgedehnten zweiten Bereichen (240) entsprechen, kein Klebstoff aufgetragen wird, so dass diese Bereiche am fertigen Mehrschichtelement kleberfrei sind.

4. Verfahren nach Anspruch 1 oder 2, **dadurch gekennzeichnet, dass** in Bereichen, die lateral ausgedehnten zweiten Bereichen (250) entsprechen, Kleber nach einem vorgegebenen Muster so aufgetragen wird, dass in lateral ausgedehnten zweiten Bereichen eine räumliche Verteilung von Haftzonen mit zwischenliegenden kleberfreien Zwischenbereichen entsteht, wobei vorzugsweise Kleber so aufgetragen wird, dass ein Flächenanteil von Kleber zur Erzeugung von Haftzonen (626) innerhalb der lateral ausgedehnten zweiten Bereiche (650) bei weniger als 10% liegt, insbesondere zwischen 1% und 5%, während ein Flächenanteil von Haftzonen in den ersten Bereichen (640) 20% oder mehr beträgt, wobei der Flächenanteil vorzugsweise im Bereich von 40% bis 90% liegt.

5. Verfahren nach einem der vorhergehenden Ansprüche, **dadurch gekennzeichnet, dass** das Klebermaterial in den ersten Bereichen (240) zur Erzeugung der Haftzonen (224) partiell nach einem vorgegebenen Muster aufgetragen wird, worin das Muster ein regelmäßiges oder unregelmäßiges Punktemuster enthält oder durch ein solches gebildet ist und/oder worin das Muster ein regelmäßiges oder unregelmäßiges Linienmuster enthält oder durch ein solches gebildet ist.

6. Verfahren nach einem der vorhergehenden Ansprüche, **dadurch gekennzeichnet, dass** die Kleberschicht in einigen oder allen ersten Bereichen so aufgebracht wird, dass im Bereich von Randzonen der ersten Bereiche dem Randverlauf angepasste linienförmige Haftzonen (424) erzeugt werden.

7. Verfahren nach einem der vorhergehenden Ansprüche, **dadurch gekennzeichnet, dass** eine lateral strukturierte Multi-Kleberschicht erzeugt wird, die im Bereich erster Haftzonen (224A) aus einem ersten Klebermaterial und im Bereich davon gesonderter zweiter Haftzonen (224B) aus einem zweiten Klebermaterial besteht, das sich vom ersten Klebermaterial unterscheidet.

8. Verfahren nach einem der vorhergehenden Ansprüche, **dadurch gekennzeichnet, dass** die lateral strukturierte Kleberschicht mittels eines Strahldruckverfahrens oder mittels eines Flexodruckverfahren auf das Substrat oder auf die Leiterfolie aufgetragen wird.

9. Verfahren nach einem der vorhergehenden Ansprüche, **dadurch gekennzeichnet, dass** zum Strukturieren der Leiterfolie mittels eines Laserbearbeitungssystems (150) Laserstrahlung entlang der Grenzen der ersten Bereiche eingestrahlt wird, wobei vorzugsweise das Laserbearbeitungssystem (150) beim Abfahren der Grenzen der ersten Bereiche in einem ersten Betriebsmodus betrieben wird und zum Bearbeiten anderer Bereiche von dem ersten Betriebsmodus in einen zweiten Betriebsmodus umgestellt wird.

10. System zum Herstellen eines Mehrschichtelements mit einem Substrat (200) und mindestens einer mit dem Substrat flächig verbundenen Leiterstruktur, die erste Bereiche (240) aus elektrisch leitendem Material aufweist, welches nach einem vorgegebenen Muster vorliegt, wobei zwischen den ersten Bereichen elektrisch nicht leitende zweite Bereiche (240) liegen, insbesondere zum Herstellen von RFID-Antennen oder flexiblen Leiterplatten in einem Rolle-zu-Rolle-Verfahren, **gekennzeichnet durch**
Einrichtungen zum Verbinden einer Leiterfolie (142) mit dem Substrat (200) mittels einer zwischenliegenden lateral strukturierten Kleberschicht (220) derart, dass in den ersten Bereichen (240) ein partieller Haftkontakt zwischen dem Substrat und der Leiterfolie an einer Vielzahl von Haftzonen (224) derart vorliegt, dass zwischen den Haftzonen kleberfreie Zwischenbereiche liegen, die durch die Leiterfolie überbrückt werden, und die Leiterfolie in lateral ausgedehnten zweiten Bereichen (250) nicht oder weniger fest durch Kleber mit dem Substrat verbunden ist;
einer Einrichtung (140) zum Strukturieren der Leiterfolie durch Schneiden der Leiterfolie entlang von Grenzen der ersten Bereiche (240); und
einer Reinigungseinrichtung (160) zum Entfernen von Folienstücken (142') der Leiterfolie (142) aus lateral ausgedehnten zweiten Bereichen derart, dass Folienstücke in den ersten Bereichen nicht abgelöst, sondern im Bereich der Haftzonen (224) am Substrat (200) festgehalten werden,
wobei die Einrichtungen zum Verbinden der Leiterfolie mit dem Substrat mindestens eine Kleberauftragseinrichtung (130) zum Auftragen einer Kleberschicht auf das Substrat (200) und/oder auf die Leiterfolie (142) aufweisen, wobei die Kleberauftragsvorrichtung derart eingerichtet ist, dass die Kleberschicht in den ersten Bereichen eine Vielzahl von Haftzonen (224) mit zwischenliegenden kleberfreien Bereichen bildet,
wobei die Kleberauftragseinrichtung eine Flexodruckwerk oder ein Strahldruckwerk oder eine Siebdruckeinrichtung oder eine Offsetdruckeinrichtung oder eine Slot-Dye-Coating-Einrichtung oder eine Tiefdruckeinrichtung zum Aufbringen einer lateral strukturierten Kleberschicht aufweist.

11. System nach Anspruch 10, **dadurch gekennzeichnet, dass** die Einrichtung (140) zum Strukturieren der Leiterfolie ein Laserbearbeitungssystem (150) aufweist.

12. Mehrschichtelement, insbesondere RFID-Antenne (300) oder flexible Leiterplatte, hergestellt oder herstellbar durch ein Verfahren nach einem der Ansprüche 1 bis 9.

13. Mehrschichtelement nach Anspruch 12, **dadurch gekennzeichnet, dass** das Mehrschichtelement ein Substrat (200) und mindestens eine mit dem Substrat mittels einer Kleberschicht (220) verbundene Leiterstruktur (145) aufweist, die erste Bereiche aus elektrisch leitenden Material aufweist, welches nach einem vorgegebenen Muster auf der Kleberschicht (220) vorliegt, wobei angrenzend an erste Bereiche elektrisch nicht leitende zweite Bereiche (250) liegen,
wobei in einigen oder allen ersten Bereichen eine Vielzahl von Haftzonen (224) der Kleberschicht nach einem vorgegebenen Muster verteilt vorliegt, wobei zwischen den Haftzonen kleberfreie Zwischenbereiche (225) vorliegen, die durch die Leiterfolie überbrückt werden, wobei vorzugsweise lateral ausgedehnte zweite Bereiche frei von Klebermaterial sind.

## Claims

1. Method for producing a multilayer element with a substrate and at least one conductor structure connected in an areal manner to the substrate, which has first regions of electrically conductive material that is present in accordance with a prescribed pattern, electrically non-conductive second regions lying between the first regions, in particular for producing RFID antennas or flexible printed circuit boards in a roller-to-roller process, **characterized by** the following steps:
connecting a conductor foil (142) to the substrate (200) by means of a laterally structured layer of adhesive (220) lying in between, in such a way that in the first regions (240) a partial bonding contact between the substrate and the conductor foil is created at a multiplicity of bonding zones (224) in such a way that between the bonding zones adhesive-free intermediate regions are located, which are bridged by the conductor foil, and in laterally extended second regions (250) the conductor foil is not connected or is connected less firmly by adhesive to the substrate;
structuring the conductor foil by cutting the conductor foil along boundaries of the first regions; and
removing contiguous pieces of foil (142') of the conductor foil (142) from laterally extended second regions (250), wherein pieces of foil in the first regions are not detached, but are securely held on the substrate (200) in the region of the bonding zones.

2. Method according to claim 1, **characterized in that** an area fraction of adhesive for creating the bonding zones (224) within the first regions (240) lies between 10% and 90%.

3. Method according to claim 1 or 2, **characterized in that** no adhesive is applied in regions that correspond to the laterally extended second regions (240), so that these regions are free of adhesive on the finished multilayer element.

4. Method according to claim 1 or 2, **characterized in that** in regions that correspond to laterally extended second regions (250) adhesive is applied in accordance with a prescribed pattern in such a way as to create in laterally extended second regions a spatial distribution of bonding zones with adhesive-free intermediate regions lying in between, wherein preferably adhesive is applied in such a way that an area fraction of adhesive for creating bonding zones (626) within the laterally extended second regions (650) lies at less than 10%, in particular between 1% and 5%, while an area fraction of bonding zones in the first regions (640) is 20% or more, the area fraction preferably lying in the range from 40% to 90%.

5. Method according to any of the preceding claims, **characterized in that** the adhesive material is applied in the first regions (240) to create the bonding zones (224) partially in accordance with a prescribed pattern, wherein the pattern contains a regular or irregular pattern of points or is formed by such a pattern, and/or wherein the pattern contains a regular or irregular pattern of lines or is formed by such a pattern.

6. Method according to any of the preceding claims, **characterized in that** the layer of adhesive is applied in some or all of the first regions in such a way that, in the region of peripheral zones of the first regions, linear bonding zones (424) adapted to the path of the periphery are created.

7. Method according to any of the preceding claims, **characterized in that** a laterally structured multilayer of adhesive is created, which in the region of first bonding zones (224A) consists of a first adhesive material and in the region of second bonding zones (224B), separate from the first, consists of a second adhesive material, which differs from the first adhesive material.

8. Method according to any of the preceding claims, **characterized in that** the laterally structured layer of adhesive is applied to the substrate or to the conductor foil by means of a jet printing process or by means of a flexographic printing process.

9. Method according to any of the preceding claims, **characterized in that**, to structure the conductor foil, laser radiation is radiated along the boundaries of the first regions by means of a laser machining system (150), wherein preferably, when passing over the boundaries of the first regions, the laser machining system (150) is operated in a first operating mode and, for machining other regions, is changed over from the first operating mode into a second operating mode.

10. System for producing a multilayer element with a substrate (200) and at least one conductor structure connected in an areal manner to the substrate, which has first regions (240) of electrically conductive material that is present in accordance with a prescribed pattern, electrically non-conductive second regions (240) lying between the first regions, in particular for producing RFID antennas or flexible printed circuit boards in a roller-to-roller process, **characterized by**
devices for connecting a conductor foil (142) to the substrate (200) by means of a laterally structured layer of adhesive (220) lying in between, in such a way that in the first regions (240) there is a partial bonding contact between the substrate and the conductor foil at a multiplicity of bonding zones (224) in such a way that between the bonding zones adhesive-free intermediate regions are located, which are bridged by the conductor foil, and in laterally extended second regions (250) the conductor foil is not connected or is connected less firmly by adhesive to the substrate;
a device (140) for structuring the conductor foil by cutting the conductor foil along boundaries of the first regions (240); and
a cleaning device (160) for removing pieces of foil (142') of the conductor foil (142) from laterally extended second regions in such a way that pieces of foil in the first regions are not detached, but are securely held on the substrate (200) in the region of the bonding zones (224),
wherein the devices for connecting the conductor foil to the substrate have at least one adhesive applying device (130) for applying a layer of adhesive to the substrate (200) and/or to the conductor foil (142), the adhesive applying device being designed in such a way that the layer of adhesive in the first regions forms a multiplicity of bonding zones (224) with adhesive-free regions lying in between,
wherein the adhesive applying device has a flexographic printing unit or a jet printing unit or a screen-printing device or an offset printing device or a slot-dye-coating device or an intaglio printing device for applying a laterally structured layer of adhesive.

11. System according to claim 10, **characterized in that** the device (140) for structuring the conductor foil has a laser machining system (150).

12. Multilayer element, in particular an RFID antenna (300) or a flexible printed circuit board, that is produced or can be produced by a method according to any of claims 1 to 9.

13. Multilayer element according to claim 12, **characterized in that** the multilayer element has a substrate (200) and at least one conductor structure (145) which is connected to the substrate by means of a layer of adhesive (220) and has first regions of electrically conductive material that is present on the layer of adhesive (220) in accordance with a prescribed pattern, electrically non-conductive second regions (250) lying adjacent to first regions,
wherein in some or all of the first regions a multiplicity of bonding zones (224) of the layer of adhesive are present in a distributed manner in accordance with a prescribed pattern, wherein adhesive-free intermediate regions (225) are located between the bonding zones, which are bridged by the conductor foil, wherein preferably laterally extended second regions are free of adhesive material.

## Revendications

1. Procédé de fabrication d'un élément multicouche comprenant un substrat et au moins une structure conductrice qui est reliée de manière sensiblement bidimensionnelle au substrat et qui comporte des premières régions en matériau électriquement conducteur qui est présent selon un motif prédéterminé, des deuxièmes régions non électriquement conductrices étant entre les premières régions et étant destinées en particulier à la fabrication d'antennes RFID ou de cartes de circuit imprimé flexibles dans un procédé rouleau à rouleau, le procédé étant **caractérisé par** les étapes suivantes:
relier un film conducteur (142) au substrat (200) au moyen d'une couche adhésive intermédiaire (220) structurée latéralement de sorte que, dans les premières régions (240), un contact adhésif partiel soit établi entre le substrat et le film conducteur au niveau d'un grand nombre de zones adhésives (224) de sorte que des régions intermédiaires sans adhésif soient présentes entre les zones adhésives, lesquelles régions intermédiaires sont recouvertes par le film conducteur, et de sorte que le film conducteur ne soit pas relié au substrat par un adhésif, ou ne le soit que faiblement, dans des deuxièmes régions étendues latéralement (250);
structurer le film conducteur par découpage du film conducteur le long de limites des premières régions; et
retirer des morceaux contigus (142') du film conducteur (142) de deuxièmes régions étendues latéralement (250), les morceaux de film n'étant pas détachés dans les premières zones, mais étant maintenus au niveau des zones adhésives du substrat (200).

2. Procédé selon la revendication 1, **caractérisé en ce qu'**un pourcentage de surface d'adhésif destiné à générer les zones adhésives (224) dans les premières régions (240) est compris entre 10 % et 90 %.

3. Procédé selon la revendication 1 ou 2, **caractérisé en ce qu'**aucun adhésif n'est appliqué dans les régions correspondant aux deuxièmes régions étendues latéralement (240) de sorte que ces zones sont exemptes d'adhésif au niveau de l'élément multicouche complété.

4. Procédé selon la revendication 1 ou 2, **caractérisé en ce qu'**un adhésif est appliqué dans des régions correspondant aux deuxièmes régions étendues latéralement (250) selon un motif prédéterminé de sorte qu'une répartition spatiale de zones adhésives pourvues de régions intermédiaires sans adhésif soient générées dans des deuxièmes régions étendues latéralement, l'adhésif étant de préférence appliqué de manière à ce qu'un pourcentage de surface d'adhésif destiné à générer des zones adhésives (626) dans les deuxièmes régions étendues latéralement (650) soit inférieur à 10 %, notamment soit compris entre 1 % et 5 %, tandis qu'un pourcentage de surface de zones adhésives dans les premières régions (640) est supérieur ou égal à 20 %, le pourcentage de surface étant de préférence dans la gamme de 40 % à 90 %.

5. Procédé selon l'une des revendications précédentes, **caractérisé en ce que** le matériau adhésif des premières régions (240) destiné à générer les zones adhésives (224) est appliqué partiellement selon un motif prédéterminé, le motif contenant un motif de points régulier ou irrégulier ou étant formé par celui-ci et/ou le motif contenant un motif de lignes régulier ou irrégulier ou étant formé par celui-ci.

6. Procédé selon l'une des revendications précédentes, **caractérisé en ce que** la couche adhésive est appliquée dans tout ou partie des premières régions de manière à générer au niveau de zones de bord des premières régions des zones adhésives linéaires (424) adaptées au contour du bord.

7. Procédé selon l'une des revendications précédentes, **caractérisé en ce qu'**une couche adhésive multiple structurée latéralement est générée, laquelle comprend un premier matériau adhésif au niveau des premières zones adhésives (224A) et, au niveau des deuxièmes zones adhésives (224B) distinctes de celles-ci, un deuxième matériau adhésif différant du premier matériau adhésif.

8. Procédé selon l'une des revendications précédentes, **caractérisé en ce que** la couche adhésive structurée latéralement est appliquée sur le substrat ou sur le film conducteur au moyen d'un procédé d'impression par jet ou au moyen d'un procédé d'impression flexographique.

9. Procédé selon l'une quelconque des revendications précédentes, **caractérisé en ce que**, pour structurer le film conducteur au moyen d'un système de traitement laser (150), un rayonnement laser est émis le long des limites des premières régions, le système de traitement au laser (150) étant utilisé de préférence dans un premier mode de fonctionnement lorsque les limites des premières régions sont côtoyées et étant commuté du premier mode de fonctionnement dans un deuxième mode de fonctionnement pour le traitement d'autres zones.

10. Système de fabrication d'un élément multicouche comprenant un substrat (200) et au moins une structure conductrice reliée de manière sensiblement bidimensionnelle au substrat et comportant des premières régions (240) en matériau électriquement conducteur présent selon un motif prédéterminé, des deuxièmes régions (240) électriquement non conductrices, destinées en particulier à la fabrication d'antennes RFID ou de cartes de circuit imprimé flexibles dans un processus rouleau à rouleau, étant présentes entre les premières régions, **caractérisé par**
des moyens de liaison d'un film conducteur (142) au substrat (200) au moyen d'une couche adhésive intermédiaire (220) structurée latéralement de sorte que, dans les premières régions (240), un contact adhésif partiel soit établi entre le substrat et le film conducteur au niveau d'un grand nombre de zones adhésives (224) de sorte que des régions intermédiaires sans adhésif soient présentes entre les zones adhésives, lesquelles régions intermédiaires sont recouvertes par le film conducteur, et de sorte que le film conducteur ne soit pas relié au substrat par un adhésif, ou ne le soit que faiblement, dans des deuxièmes régions étendues latéralement (250);
un moyen (140) pour structurer le film conducteur par découpage du film conducteur le long des limites des premières régions (240); et
un moyen de nettoyage (160) destiné à retirer des morceaux (142') du film conducteur (142) des deuxièmes régions étendues latéralement de sorte que les morceaux de film des premières régions ne soient pas détachés mais soient maintenus au niveau des zones adhésives (224) du substrat (200),
les moyens de liaison du film conducteur au substrat comportant au moins un moyen d'application d'adhésif (130) destiné à appliquer une couche adhésive sur le substrat (200) et/ou sur le film conducteur (142), le dispositif d'application d'adhésif étant conçu de telle sorte que la couche adhésive des premières régions forme un grand nombre de zones adhésives (224) pourvues de régions intermédiaires exemptes d'adhésif,
le moyen d'application d'adhésif comportant une unité d'impression flexographique ou une unité d'impression à jet ou un dispositif de sérigraphie ou un dispositif d'impression offset ou un dispositif d'enduction par filière à fente (Slot Die Coating) ou un dispositif d'impression en creux pour appliquer une couche adhésive structurée latéralement.

11. Système selon la revendication 10, **caractérisé en ce que** le moyen (140) destiné à structurer le film conducteur comporte un système de traitement laser (150).

12. Elément multicouche, en particulier antenne RFID (300) ou carte de circuit imprimé souple, fabriqué ou pouvant être fabriqué par un procédé selon l'une des revendications 1 à 9.

13. Elément multicouche selon la revendication 12, **caractérisé en ce que** l'élément multicouche comporte un substrat (200) et au moins une structure conductrice (145) reliée au substrat au moyen d'une couche adhésive (220) et comportant des premières régions en matériau électriquement conducteur qui est présent sur la couche adhésive (220) selon un motif prédéterminé, des deuxièmes régions (250) électriquement conductrices étant présentes de manière adjacente à des premières régions,
un grand nombre de zones adhésives (224) de la couche adhésive étant réparties dans tout ou partie des premières régions selon un motif prédéterminé, des régions intermédiaires (225) sans adhésif étant présentes entre les zones adhésives, lesquelles régions intermédiaires sont recouvertes par le film conducteur, des deuxièmes régions étendues latéralement étant de préférence exemptes de matériau adhésif.
